Europäisches Patentamt

European Patent Office

Office européen des brevets

(19)

(11) Numéro de publication: **0 084 997 B1**

(12) **FASCICULE DE BREVET EUROPEEN**

(45) Date de publication du fascicule du brevet:
04.12.85

(51) Int. Cl.⁴: **H 03 C 1/60**

(21) Numéro de dépôt: 83400103.4

(22) Date de dépôt: 14.01.83

(54) **Dispositif de modulation pour chaîne de modulation de type à bande latérale unique.**

(30) Priorité: 26.01.82 FR 8201205

(43) Date de publication de la demande:
03.08.83 Bulletin 83/31

(45) Mention de la délivrance du brevet:
04.12.85 Bulletin 85/49

(84) Etats contractants désignés:
DE GB

(56) Documents cités:
GB - A - 811 540
US - A - 2 059 719
US - A - 2 848 687
US - A - 2 903 518

(73) Titulaire: THOMSON-CSF, 173, Boulevard Haussmann, F-75379 Paris Cedex 08 (FR)

(72) Inventeur: de Riviere, Charles, THOMSON-CSF
SCPI 173, bld Haussmann, F-75379 Paris Cedex 08 (FR)

(74) Mandataire: Turlèque, Clotilde et al, THOMSON-CSF
SCPI 173, Bld Haussmann, F-75379 Paris Cedex 08 (FR)

## Description

L'invention concerne un dispositif de modulation pour chaîne de modulation de type à bande latérale unique (BLU).

La modulation BLU consiste à moduler en amplitude une onde porteuse délivrée par un oscillateur local et à exécuter un filtrage du signal modulé ainsi obtenu, de manière à ne conserver qu'une des bandes latérales du spectre de fréquence du signal modulé. On distingue la modulation BLU inférieure qui conserve le signal modulé de fréquence inférieure à la fréquence de l'onde porteuse, et la modulation BLU supérieure qui conserve le signal modulé de fréquence supérieure à la fréquence de l'onde porteuse.

Ce procédé de modulation présente l'avantage par rapport à la modulation d'amplitude classique, et à puissance d'émetteur égale, d'améliorer le rapport signal sur bruit à l'émission d'une quantité égale à 9 dB. Ce gain est un résultat bien connu de la modulation BLU et est ce qui en fait son attrait.

Quand la limitation de la puissance d'émission des émetteurs est imposée, limitation technologique dans les émetteurs de grande portée ou limitation administrative dans les configurations d'allocation des diverses gammes de fréquence, il est encore possible d'améliorer le rapport signal sur bruit en jouant sur la forme même du signal modulant.

En effet le signal modulant, dans le cas de la parole surtout, présente une variation d'amplitude importante, de l'ordre de 10 dB environ, qui est le fait des syllabes plosives commençant généralement par des lettres telles que les b, les p, ou les t, et ceci même pour un orateur parlant d'une voix égale. La puissance d'émission nominale d'un émetteur est donc celle affectée à l'émission de ces signaux les plus forts. Or il s'avère que ces signaux ne représentent qu'une petite proportion des quantités d'information à transmettre et ne sont pas entièrement nécessaires à l'intelligibilité d'un message. Soit P crête la puissance déployée par un émetteur pour émettre ces signaux de grande amplitude et P moyen la puissance déployée pour émettre la majeure partie des messages. On sait, dans ce cas, que le rapport signal utile sur bruit est égal à P moyen/P bruit et que la puissance nominale de l'émetteur est égale à P crête. On en déduit facilement que l'émetteur émet quasiment en permanence à une puissance inférieure à sa puissance nominale, et que le rapport signal sur bruit peut être amélioré dans le rapport P crête/P moyen.

Une première solution, imaginée dans l'art antérieur pour réduire cette variation d'amplitude vocale, consistait à réaliser un écrêtement du signal modulant; mais on était rapidement limité par les pertes d'intelligibilité dues aux distorsions. Une deuxième solution, imaginée dans l'art antérieur, consistait à réguler le gain de la chaîne d'émission BLU par un automatisme, appelé compresseur, et à donner à ce compresseur une constante de temps de l'ordre de 20 à 50 ms. Dans ces conditions on ne tenait pas compte de la variation d'amplitude due aux syllabes plosives du signal modulant, même de celles dont la fréquence était la plus basse, mais seulement des intonations que l'orateur voulait imprimer à son discours. Ce dispositif permettait d'améliorer le rapport signal sur bruit d'environ 6 dB.

La méthode la plus efficace, qui permet d'augmenter au maximum la puissance moyenne, et donc le rapport signal sur bruit, sans altérer sensiblement l'intelligibilité, consiste à écrêter le signal en BLU, car, en BLU, une partie de la quantité d'information à transmettre est véhiculée par une modulation de la phase de la porteuse. Ceci s'explique de la manière suivante: soit $\omega_p$ la pulsation de l'onde porteuse et $\omega_m$ la pulsation du signal modulant, la valeur du signal modulé en BLU est $m \cos (\omega_p \pm \omega_m) t$, selon que l'on pratique une modulation BLU supérieure ou inférieure; un écrêtement en BLU revient à agir sur m quand m est trop grand du fait d'un signal modulant trop fort; le signal, perçu après cet écrêtement, est certes $m' \cos (\omega_p \pm \omega_m) t$, avec $m' < m$, mais comporte par contre l'information $\omega_m$ de nature à assurer l'intelligibilité du message. Dans ces conditions la puissance moyenne d'émission peut se rapprocher le plus de la puissance nominale de l'émetteur, et le rapport signal sur bruit peut s'approcher le plus de son maximum.

Dans l'art antérieur cet écrêtement BLU, réalisé après le filtrage BLU, nécessite un filtrage complémentaire pour limiter, à sa partie utile seulement, la bande de fréquence explorée par le signal modulé. En effet l'écrêtement BLU, s'il ne modifie pas notablement le spectre du signal modulé, a cependant pour conséquence de générer des harmoniques de ce signal modulé. Il convient, avant de transmettre, d'éliminer ces harmoniques. Sur le plan pratique le filtre complémentaire nécessaire est identique au premier filtre BLU.

Par ailleurs le besoin se fait sentir, dans l'industrie, de réaliser ds émetteurs BLU pouvant émettre au choix sur l'un des deux canaux: le canal BLU supérieure ou le canal BLU inférieure. Ce besoin se fait particulièrement sentir en transmission radioélectrique ou la permutation des canaux est une pratique courante pour pallier certains inconvénients de transmission des ondes dans l'atmosphère.

Un dispositif de ce type a été décrit dans le brevet US-A-2 848 687. Dans ce dispositif, un premier filtre sélectionne toujours après modulation d'une porteuse Fo la même bande latérale soit Fo + f et l'une ou l'autre des deux bandes est sélectionnée par un deuxième filtrage à bande assez large centrée sur 3Fo après mélange de la première bande latérale filtrée avec l'une ou l'autre de 2 fréquences porteuses différentes (2Fo ou 4Fo). L'équipement de ces deux canaux avec un dispositif d'écrêtement comme indiqué ci-dessus nécessiterait la réalisation de deux filtres à bandes étroites: un filtre accordé sur la bande de fréquence inférieure et un filtre accordé sur la bande de fréquence supérieure. Ces filtres d'une technologie très élaborée, filtres à quartz en particulier, sont réalisés un par un, avec beaucoup d'opérations manuelles, et sont en conséquence très coûteux. Il importe d'en réduire le nombre.

La présente invention a pour objet d'associer deux dispositifs: à savoir un dispositif d'émetteurs double canaux: BLU intérieure et BLU supérieure, et un dispositif d'écrêtement BLU pour augmenter le rapport signal sur bruit, tout en diminuant le nombre des filtres nécessaires pour réaliser ces opérations par rapport au nombre de filtres utilisés dans l'art antérieur.

L'invention consiste en un dispositif de modulation, pour chaîne de modulation de type à bande latérale unique, comportant:

— un premier modulateur pour moduler un premier signal de porteuse par un signal modulant (BF) et délivrer un premier signal modulé comportant une première bande latérale inférieure et une première bande latérale supérieure;
— un premier filtre pour recevoir le premier signal modulé, éliminer l'une des deux premières bandes latérales et délivrer l'autre;
— un deuxième modulateur couplé à la sortie du premier filtre pour moduler, par le signal qu'il reçoit, un deuxième signal de porteuse,
— un deuxième filtre pour recevoir le deuxième signal modulé, et sélectionner la bande latérale utile,

le dispositif de modulation étant caractérisé:

— en ce qu'un dispositif de traitement de signal est prévu entre la sortie du premier filtre et l'entrée du second modulateur,
— en ce que le deuxième signal de porteuse est à fréquence fixe double de celle du premier signal de porteuse,
— et, en ce que les premier et second filtres sont des filtres passe bande sélectifs appariés, de bandes dites inférieure et supérieure et symétriques par rapport à la fréquence du premier signal de porteuse, le dispositif demodulation comportant en outre des moyens de commutation permettant d'utiliser le filtre de bande inférieure comme premier filtre et le filtre de bande supérieure comme deuxième filtre pour une transmission en bande latérale supérieure et inversement pour une transmission en bande latérale inférieure.

L'invention sera mieux comprise et d'autres caractéristiques apparaîtront à l'aide de la description qui suit en référence aux figures annexées. Celles-ci sont données à titre indicatif et non limitatif des caractéristiques de l'invention. Elles représentent:

— la figure 1, un dispositif de modulation BLU sur le canal supérieur;
— la figure 2, un dispositif de modulation BLU sur le canal inférieur;
— la figure 3, un schéma global du dispositif de modulation BLU double canal selon l'invention.

Sur ces différentes figures les mêmes repères désignent les mêmes éléments.

En disposant un filtre BLU inférieure après un mélangeur mélangeant le signal modulant de fréquence f et la porteuse émise par un oscillateur local de fréquence Fol, le mélange $Fol \pm f$, sortant du mélangeur, devient $Fol - f$. Un dispositif de traitement de signal, situé à la suite du mélangeur, ne modifie pas d'une manière fondamentale le spectre de ce dernier signal. C'est-à-dire que le spectre du signal émergent de ce dispositif de traitement de signal contient d'une part les composantes $Fol - f$ et d'autre part des harmoniques de ce signal. Plus particulièrement dans le cas qui nous préoccupe ce dispositif de traitement de signal sera un écrêteur BLU, mais cela n'est nullement une condition restrictive du champ d'application de l'invention qui est plus vaste. Un deuxième mélangeur mélangeant ce signal à celui d'un oscillateur dont la fréquence est le double exactement, 2Fol, de celle du premier oscillateur local produit un signal:

$$\{2Fol \pm (Fol - f)\}$$

qui peut encore s'écrire: $Fol + f$ et $3Fol - f$.

Le passage de ce dernier signal dans un filtre BLU supérieur élimine la composante $3Fol - f$ et restitue le signal utile $Fol + f$. On voit que l'on obtenu un signal modulé en BLU, ayant subi un écrêtement BLU, et utilisé deux filtres différents appariés.

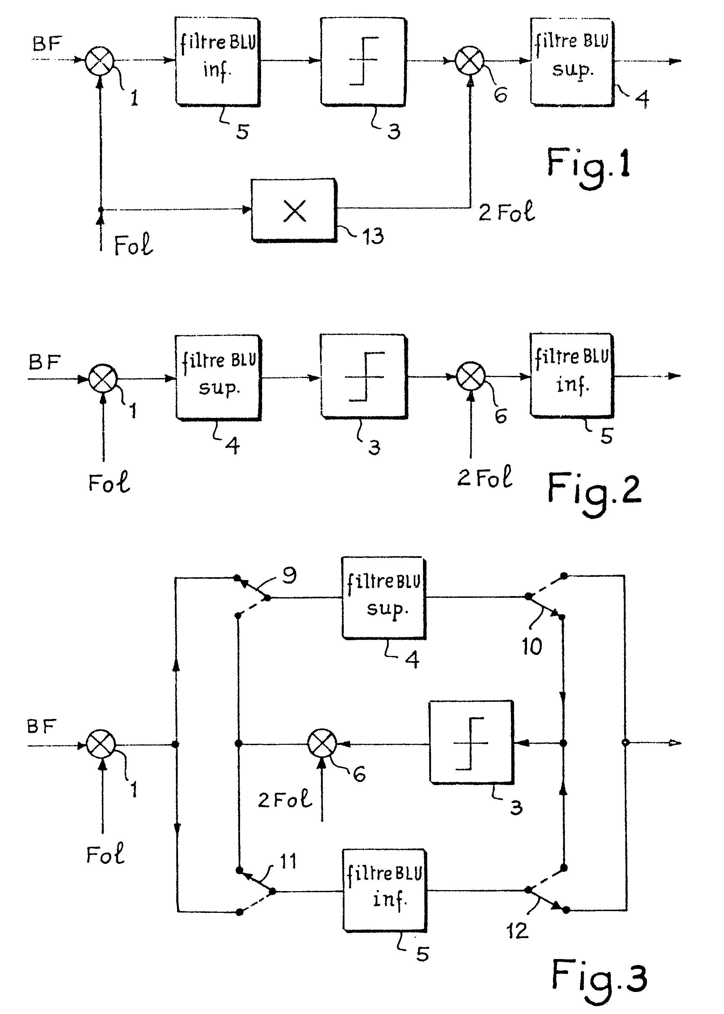

On a représenté sur la figure 1 le schéma d'un modulateur-écrêteur BLU. Un signal de modulation, référencé par les lettres BF, arrive sur l'une des voies d'un mélangeur 1. Une onde porteuse, de fréquence Fol, arrive sur l'autre voie en provenance d'un oscillateur local non représenté. Le signal modulé, élaboré par le mélangeur 1, attaque un filtre BLU 5, filtre BLU inférieure qui a pour objet d'éliminer la partie inutile du signal élaboré par le mélangeur. Un écrêteur BLU 3 réalise un écrêtement du signal modulé. Un mélangeur 6 est intercalé entre l'écrêteur BLU 3 et un filtre BLU supérieure 4. Les filtres 4 et 5 sont des filtres passe-bande ayant des caractéristiques de filtrage très sélectives. Ils sont généralement constitués d'une série de cellules à quartz: le nombre des cellules est directement lié à la raideur des flancs de la courbe de réponse en fréquence de ces filtres. La construction à base de quartz de chacune de ces cellules leur confère une grande sélectivité, de l'ordre de quelques kilohertz autour d'une fréquence d'oscillateur de plusieurs mégahertz. Le réglage de l'accord de ces filtres est très délicat et très précis. Le mélangeur 6 reçoit un signal venant de l'écrêteur BLU 3 et un signal émis par un multiplicateur 13 de l'oscillateur local. La fréquence du signal émis par le multiplicateur est le double exactement de la fréquence de la porteuse initiale.

Le signal sortant du mélangeur 6 comporte donc un spectre de composantes Fol+f et de composantes 3Fol—f comme il a été dit précédemment. En effet le signal sortant de l'écrêteur BLU 3 est obtenu par battement du signal modulant, noté BF, et dont la fréquence est f, avec le signal émanant d'un oscillateur local, non représenté, dont la fréquence est Fol. Ce battement est effectué dans le mélangeur 1, classique. Le spectre du signal sortant de mélangeur 1 comporte, en particulier, des composantes Fol—f et Fol+f. Le passage de ce signal dans le filtre BLU inférieure 5 supprime la composante Fol+f. Il reste donc la composante Fol—f. Ce signal, sortant du filtre BLU inférieure 5, attaque l'écrêteur BLU 3 qui provoque entre autres la génération d'harmoniques du signal Fol—f. Le signal sortant de cet écrêteur BLU 3 est appliqué a l'une des voies du mélangeur 6. L'autre voie de ce mélangeur 6 recevant le signal de fréquence 2 Fol issu du multiplicateur 13. Le battement de ces deux derniers signaux dans le mélangeur 6 génère un signal dont le spectre comporte les composantes significatives:

$$2Fol—(Fol—f) \text{ et } 2Fol + (Fol—f).$$

Ceci peut encore s'écrire:

$$Fol + f \text{ et } 3Fol—f.$$

Le filtre BLU supérieure 4 permet de retrouver en sortie le signal de spectre Fol+f en éliminant la composante 3Fol—f ainsi que les harmoniques parasites émises par l'écrêteur BLU 3 éventuellement transposées par le modulateur 6. Le dispositif de la figure 1 permet donc l'émission sur le canal supérieur.

La figure 2 représente une configuration symétrique de la précédente dans laquelle les filtres BLU supérieure 4 et les filtres BLU inférieure 5 ont été intervertis. Le dispositif dela figure 2, symétrique de celui de la figure 1 permet l'émission sur le canal inférieur. Dans chacune de ces deux configurations on remarque que seuls deux filtres ont été utilisés, un filtre BLU supérieure 4 et un filtre BLU inférieure 5.

Un dispositif de commutation à partir de deux filtres appariés, permet de réaliser un dispositif de modulation selon l'invention sur un quelconque des canaux, le canal supérieur ou le canal inférieur. Ce dispositif est décrit par la figure 3. Sur cette figure on remarque en particulier un ensemble de contacteurs 9, 10, 11 et 12 organisant au choix le parcours du signal selon une des deux configurations décrites en figures 4 et 5. La commutation de tous ces contacteurs 9, 10, 11 et 12 est simultanée selon un dispositif connu de l'art antérieur et non représenté sur la figure. On remarque en particulier sur cette figure un commutateur 9 permettant au signal émis par le modulateur 1 d'attaquer le filtre BLU supérieure 4. Le commutateur 10 dirige le signal sortant de ce filtre BLU supérieure 4 vers l'entrée d'un écrêteur BLU 3. La sortie de cet écrêteur BLU 3 attaque un mélangeur 6 selon l'invention. La sortie de ce mélangeur 6 est dirigée vers l'entrée du filtre BLU inférieure 5 par l'intermédiaire du commutateur 11. Le signal sortant de ce filtre BLU inférieure 5 est dirigé vers son traitement ultérieur par l'intermédiaire du dernier commutateur 12. On constate que, si l'on commute ensemble tous les commutateurs 9, 10, 11 et 12, le signal suivra un chemin symétrique et sera dirigé à la sortie du filtre BLU supérieure 4, vers son traitement ultérieur par le passage dans le commutateur 10. La première configuration permet l'émission sur le canal inférieur, la deuxième configuration permet l'émission sur le canal supérieur. On constate donc qu'au moyen d'un seul jeu de deux filtres appariés et au moyen d'un je de commutateurs on peut réaliser la modulation et l'écrêtement BLU sur chacun des canaux.

Un dispositif conçu selon ce dispositif global trouve son application particulièrement dans les émetteurs BLU double canaux.

Les récepteurs BLU, utilisant avant démodulation des filtres BLU associés à l'émission, les filtres ici représentés peuvent aussi remplir cette fonction.

Un dispositif conçu selon la configuration globale de la figure 3 trouve donc aussi une application dans les émetteurs-récepteurs double canaux.

## Revendications

1. Dispositif de modulation, pour chaîne de modulation de type à bande latérale unique, comportant:

— un premier modulateur (1) pour moduler un premier signal de porteuse par un signal modulant (BF) et délivrer un premier signal modulé comportant une première bande latérale inférieure et une première bande latérale supérieure;

— un premier filtre pour recevoir le premier signal modulé, éliminer l'une des deux premières bandes latéales et délivrer l'autre;

— un deuxième modulateur (6) couplé à la sortie du premier filtre pour moduler, par le signal qu'il reçoit, un deuxième signal de porteuse,

— un deuxième filtre pour recevoir le deuxième signal modulé, et sélectionner la bandelatérale utile,

le dispositif de modulation étant caractérisé:

— en ce qu'un dispositif de traitement de signal (3) est prévu entre la sortie du premier filtre et l'entrée du second modulateur,

— en ce que le deuxième signal de porteuse est à fréquence fixe double de celle du premier signal de porteuse,

— et, en ce que les premier et second filtres sont des filtres passe bande sélectifs appariés, de bandes dites inférieure ou supérieure symétriques par rapport à la fréquence du premier signal de porteuse, le dispositif de modulation comportant en outre des moyens de commutation (9—12) permettant d'utiliser le filtre à bande inférieure (5) comme premier filtre et le filtre de bande supérieure (4) comme deuxième filtre pour une transmission en bande latérale supérieure et inversement pour une transmission en bande latérale inférieure.

2. Dispositif selon la revendication 1, caractérisé en ce qu'il comprend en outre un doubleur de fréquence (13) pour recevoir le premier signal de porteuse et délivrer le deuxième signal de porteuse.

3. Dispositif selon l'une quelconque des revendications 1 à 2, caractérisé en ce que le dispositif de traitement de signal est un écrêteur bande latérale unique (3).

**Patentansprüche**

1. Modulationsvorrichtung für eine Modulationskette vom Einseitenbandtyp, enthaltend:

— einen ersten Modulator (1) zum Modulieren eines ersten Trägersignals durch ein Modulationssignal (BF) und Abgeben eines ersten modulierten Signals, welches ein erstes unteres Seitenband und ein erstes oberes Seitenband enthält;
— ein erstes Filter zum Empfangen des ersten modulierten Signals, Unterdrücken eines der zwei ersten Seitenbänder und Abgeben des anderen;
— einen zweiten Modulator (6), der an den Ausgang des ersten Filters angekoppelt ist, um ein zweites Trägersignal mit dem durch ihn empfangenden Signal zu modulieren,
— ein zweites Filter zum Empfangen des zweiten modulierten Signals und Selektieren des Nutz-Seitenbandes, wobei die Modulationsvorrichtung dadurch gekennzeichnet ist, daß:

— eine Signalverarbeitungsvorrichtung (3) zwischen dem Ausgang des ersten Filters und dem Eingang des zweiten Modulators vorgesehen ist,
— das zweite Trägersignal eine feste Frequenz aufweist, die das Zweifache der Frequenz des ersten Trägersignals beträgt,
— und daß das erste und das zweite Filter selektive gepaarte Bandpaßfilter sind, deren Bänder als oberes und unteres Band bezeichnet werden und symmetrisch in bezug auf die Frequenz des ersten Trägersignals liegen, wobei ferner die Modulationsvorrichtung Schaltmittel (9—12) enthält, die es gestatten, das untere Bandfilter (5) als erstes Filter und das obere Bandfilter (4) als zweites Filter für eine Übertragung im oberen Seitenband und umgekehrt für eine Übertragung im unteren Seitenband zu verwenden.

2. Vorrichtung nach Anspruch 1, dadurch gekennzeichnet, daß sie ferner einen Frequenzverdoppler (13) enthält, um das erste Trägersignal zu empfangen und das zweite Trägersignal abzugeben.

3. Vorrichtung nach einem der Ansprüche 1 und 2, dadurch gekennzeichnet, daß die Signalverarbeitungsvorrichtung ein Einseitenband-Begrenzer (3) ist.

**Claims**

1. Modulation device for a single sideband type modulation chain, comprising:

— a first modulator (1) for modulating a first carrier signal with a modulating signal (BF) and supplying a first modulated signal comprising a first lower sideband and a first upper sideband;
— a first filter for receiving the first modulated signal, eliminating one of the two first sidebands and supplying the other one;
— a second modulator (6) coupled to the output of the first filter for modulating a second carrier signal with the signal received thereby,
— a second filter for receiving the second modulated signal and selecting the useful sideband, the modulation device being characterized:

— in that a signal processing device is provided between the output of the first filter and the input of the second modulator,
— in that the second carrier signal has a fixed frequency of twice that of the first carrier signal,
— and in that the first and second filters are paired selective band pass filters with so-called lower and upper bands which are symmetrical with respect to the frequency of the first carrier signal, the modulation device further comprising switching means (9—12) enabling the use of the lower band filter (5) as the first filter and of the upper band filter (4) as the second filter for a transmission in the upper sideband and vice versa for a transmission in the lower sideband.

2. Device according to claim 1, characterized in that it further comprises a frequency doubler (13) for receiving the first carrier signal and supplying the second carrier signal.

3. Device according to any of claims 1 and 2, characterized in that the signal processing device is a single sideband limiter (3).

Fig.1

Fig.2

Fig.3